(19) Europäisches Patentamt
European Patent Office
Office européen des brevets

(11) **EP 2 144 364 A1**

(12) **EUROPEAN PATENT APPLICATION**

(43) Date of publication:
**13.01.2010 Bulletin 2010/02**

(51) Int Cl.:
***H03C 3/09*** *(2006.01)*

(21) Application number: **08290464.0**

(22) Date of filing: **19.05.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **NXP B.V.**
**5656 AG Eindhoven (NL)**

(72) Inventor: **The designation of the inventor has not yet been filed**

(74) Representative: **Williamson, Paul Lewis et al**
**NXP Semiconductors UK Ltd.**
**Intellectual Property Department**
**Betchworth House**
**57-65 Station Road**
**Redhill**
**Surrey RH1 1DL (GB)**

(54) **Feedback system**

(57) A feedback system (300) comprises a control system, a feedback stage (320) which includes a variable gain stage (322), and a gain controller (330). The control system (310) has an input (312) for a feedback signal and, responsive to the feedback signal, provides an error signal indicative of whether a control signal in the control system (310) is above or below a convergence value. The feedback stage (320) generates the feedback signal from the error signal. The gain controller (330) is adapted to, in response to the error signal indicating that the control signal has crossed the convergence value, reduces the gain of the variable gain stage (322).

Fig. 3

EP 2 144 364 A1

**Description**

FIELD OF THE INVENTION

The invention relates to a feedback system and to a method of operating a feedback system. The feedback system may be a phase locked loop. The invention also relates to a communication apparatus comprising a feedback system having a phase locked loop.

BACKGROUND TO THE INVENTION

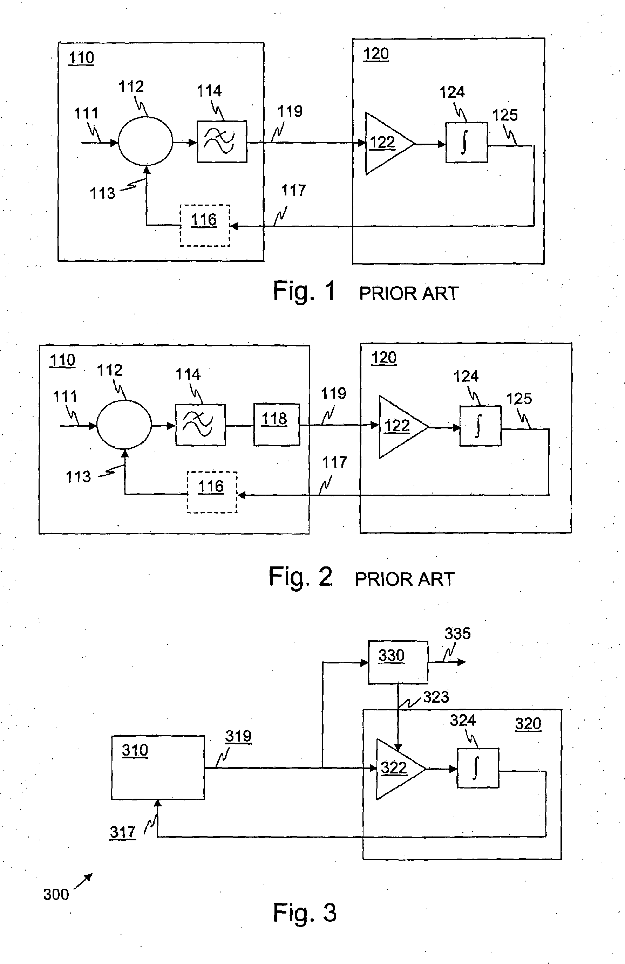

Feedback systems are used extensively in electronics for control purposes. One application is in microelectronics where feedback can be used to obtain high accuracy despite the characteristics of microelectronic devices varying with manufacturing process spread and parameters such as temperature and supply voltage. CMOS devices used in analogue applications are particularly prone to such variations because CMOS processes are mainly optimised for digital circuitry where variations can be more readily tolerated. In view of this, it is desirable to employ digital circuitry whenever possible, and when analogue circuitry is used, to employ feedback techniques to reduce the impact of such variations.
A simple, known feedback system is illustrated in Figure 1. The objective is to drive a signal appearing at an output 125 to a desired reference value applied at an input 111. An error detector 112 generates an error signal indicative of a difference between the desired reference value at the input 111 and the signal at the output 125 which is fed back to an input 113 of the error detector 112. The error signal is filtered in a filter 114, and the filtered error signal is integrated in an integrator 124. Typically, a gain stage 122 is coupled between the filter 114 and the integrator 124 for changing the magnitude of the filtered error signal. The integrated signal becomes the feedback signal. The presence of one integrator 124 in the loop leads to a final error signal being zero.
In other feedback systems, there may be other circuitry for processing the signal at the output 125 which is fed back to the input 113. For example, in a temperature control system, a heater or cooler may be controlled in response to the signal fed back from the output 125, a temperature sensor may determine, dependent on a measured temperature, the signal provide at the input 113. These two elements are represented in Figure 1 by block 116 using a broken line. Also, a thermostat may provide the desired reference value at the input 111.
In another example, the feedback system of Figure 1 may be a phase locked loop, in which case block 116 may contain a voltage controlled oscillator (VCO) having its frequency determined by the signal fed back from the output 125, a divider for dividing a signal output by the VCO to provide a signal at input 113, and a crystal oscillator for providing a desired reference frquency at the input 111. In this case the error detector 112 is a phase detector which generates an error signal indicative of a phase difference between the crystal oscillator and the divided VCO output signal applied at the input 113. The signal output by the VCO may be used, for example, as a local oscillator signal in a wireless communication transmitter or receiver.
In general, the feedback system of Figure 1 may be regarded as comprising a control system, denoted by reference numeral 110 in Figure 1, and a feedback stage, denoted by reference numeral 120 in Figure 1. The control system has an input 117 for a feedback signal and an output 119, and the control system 110 is adapted to, in response to the feedback signal, provide at the output 119 an error signal indicative of whether a control signal in the control system 110, is above or below a value to which the control signal converges due to operation of the feedback loop. This value will be referred to as the convergence value. In the feedback system of Figure 1, the control signal is the signal applied at the input 113 of the error detector 112. The feedback stage 120 has an input coupled to the output 119, and generates the feedback signal from the error signal at the output 119. In the feedback system of Figure 1, the feedback stage 120 comprises the gain stage 122 and the integrator 124.
A variation of the feedback system of Figure 1 is illustrated in Figure 2, in which the control system 110 comprises a comparator 118 coupled between the output of the filter 114 and the output 119. The comparator 118 delivers a digital signal, in the simplest case a binary signal, indicative of whether the filtered error signal is above or below a threshold value. Thus the comparator 118 functions as a simple analogue to digital converter, and enables at least the gain stage 122 and the integrator 124 to be implemented as digital circuits. Dependent on the application, some or all of the control system 110 may be implemented also as digital circuitry.
In a further example, the control system 110 of Figure 1 may be a gain control system for controlling the gain of a phase locked loop. In this case the control system 110 may comprise a phase locked loop and circuitry for generating an error signal indicative of whether a control signal indicative of whether the gain in the phase locked loop is too high or too low relative to a reference value of unity and for adjusting the gain in the loop in response.
In order to ensure the stability of feedback systems such as those described above, a trade-off must be made between the speed of convergence and the accuracy of convergence.
An objective of the invention to provide a feedback system having an improved performance.

## SUMMARY OF THE INVENTION

According to a first aspect of the invention there is provided a feedback system comprising:

- a control system having an input for a feedback signal and an output, the control system being responsive to the feedback signal and adapted to provide at the output an error signal indicative of whether a control signal in the control system is above or below a convergence value;
- a feedback stage coupled between the output and the input for generating the feedback signal from the error signal, the feedback stage having a variable gain stage; and
- a gain controller coupled to the output of the control system and to an input of the variable gain stage and adapted to, in response to the error signal indicating that the control signal has crossed the convergence value, reduce the gain of the variable gain stage.

According to a second aspect of the invention there is provided a method of operating a feedback system comprising a control system responsive to a feedback signal, the method comprising:

- generating an error signal indicative of whether a control signal in the control system is above or below a convergence value;
- generating the feedback signal from the error signal; and
- in response to the error signal indicating that the control signal has crossed the convergence value, reducing the gain of the feedback signal.

Therefore, the invention provides variable gain within a feedback loop with the gain being reduced in response to the error signal indicating that a control signal in the control system has made a transition from above to below, or from below to above, a value to which the control signal converges. In some embodiments the control signal may be the feedback signal.
Optionally, the error signal may be a digital signal, such as a binary signal. This enables the feedback stage to be solely digital.
Optionally, the feedback stage may further have an integration stage.
This prevents abrupt changes in the feedback signal and can contribute to stability of the control system
Optionally, the control system may comprise a phase locked loop.
Thus the invention has application to, for example, frequency generation, such as frequency generation in a communication apparatus. Therefore, the invention also provides a communication apparatus comprising the feedback system.
Furthermore, the invention provides computer program code for performing the method according to the second aspect of the invention.

## BRIEF DESCRIPTION OF THE DRAWINGS

The invention will now be described, by way of example only, with reference to the accompanying drawings in which:

Figure 1 is a block schematic diagram of a known feedback system;
Figure 2 is a block schematic diagram of another known feedback system;
Figure 3 is a block schematic diagram of an embodiment of a feedback system in accordance with the invention;
Figure 4 is a block schematic diagram of a feedback system comprising a phase locked loop;
Figure 5 is a more detailed block schematic diagram of the feedback system of Figure 4;
Figure 6 is a diagram showing modulation and phase error signal waveforms in-phase;
Figure 7 is a diagram showing modulation and phase error signal waveforms with a relative phase shift;
Figure 8 is a block schematic diagram of a sign detector;
Figure 9 is a diagram showing modulation and phase error signal waveforms with a relative phase shift, together with the phase of the modulation; and
Figure 10 is a block schematic diagram of a communication apparatus.

## DETAILED DESCRIPTION OF EMBODIMENTS

Referring to Figure 3, the feedback system 300 comprises a control system 310, a feedback stage 320, and a gain controller 330. The control system 310 has an input 317 for a feedback signal and an output 319. The control system 310 generates at the output 319, in response to the feedback signal, an error signal indicative of whether a control signal in the control system is above or below a convergence value. A detailed example of the control system 310 is presented below. The error signal in the embodiment of Figure 3 is a digital signal, which in the following description is a binary signal which can take the values +1 and -1 and be represented by a single bit.

The output 319 of the control system 310 is coupled to an input of the feedback stage 320 which comprises a variable gain stage 322 and an integrator 324. More specifically the output 319 of the control system 310 is coupled to an input of the variable gain stage 322 for scaling the error signal by a variable gain. The gain of the variable gain stage 322 can be varied in response to a gain control signal applied at a control input 323 of the variable gain stage 250. An output of the variable gain stage 322 is coupled to an input of the integrator 324. The variable gain stage 322 and the integrator 324 may be combined, in an integrator that also provides a variable gain. However, for clarity they are illustrated as separate elements in the embodiment of Figure 3. An output of the integrator 324 is coupled to an output of the feedback stage 320 which is coupled to the input 317 of the control system 310.

The output 319 of the control system 310 is coupled to an input of a gain controller 330 for generating the gain control signal dependent on the error signal. An output of the gain controller 330, for delivering the gain control signal, is coupled to the control input 323 of the variable gain stage 322.

The operation of the feedback system 300 is as follows. Initially, before the feedback loop has converged, such as when the feedback system 300 is powered up, or the loop formed by the control system 310 and the feedback stage 320 is closed, or a change occurs in the control system 310, the error signal will be either +1 or -1, depending on whether the value of a control signal in the control system 310 is higher or lower than a convergence value. In some applications the convergence value may be a predetermined reference value, which is some systems may be zero. In other applications, the convergence value may be determined by a state of the control system 310. Also initially, the gain controller 330 sets the gain of the variable gain stage 322 to a relatively high value. In one example this gain may be greater than unity. With the relatively high gain, the feedback system 300 will converge quickly. However, with no further steps, the error signal will oscillate over a wide range of values, causing the error signal will toggle between +1 and -1.

The gain controller 330 is adapted to detect a change in the polarity of the error signal, preferably the first change but alternatively a subsequent change. The change in the polarity indicates that the control signal has passed through the convergence value. In response to detecting the change in polarity of the error signal, the gain controller 330 reduces the gain of the variable gain stage 322 to a lower value. In one example this lower value may be less than unity. With the relatively low gain, further convergence of the feedback system 300 will proceed more slowly, and fluctuations of the control signal in the control system 310 signal will be over a narrower range, so convergence will be more accurate. The error signal can continue to toggle between +1 and -1, so the amplitude of the error signal does not reduce, but the reduced gain of the variable gain stage 322 results in the narrower fluctuations of the control signal.

Optionally, the gain controller 330 may further reduce the gain of the variable gain stage 322 in response to subsequent toggling of the error signal, further reducing fluctuations of the error signal and increasing the accuracy of convergence.

Optionally, the gain controller 330 may provide at an output 335 an indication of when the feedback system 300 has reached full or partial convergence. Such an indication may be determined depending on one or more of the following parameters: the time elapsed since powering up or closing the feedback loop; the time elapsed since the first, or a subsequent, toggling of the error signal; the time between consecutive toggles of the error signal. Such an indication of lock may be employed by other circuitry, depending on the application. For example, if the control system 310 includes a phase locked loop of a radio transmitter, the transmitter output power may be increased in response to the indication of convergence, thereby preventing transmission of undesirable spurious signals prior to convergence of the feedback system 300.

In the following paragraphs embodiments of feedback systems are described which provide examples of control systems that may be incorporated in feedback systems in accordance with the invention. Detailed examples are provided for illustration which include a phase locked loop, but the invention is not limited to such control systems.

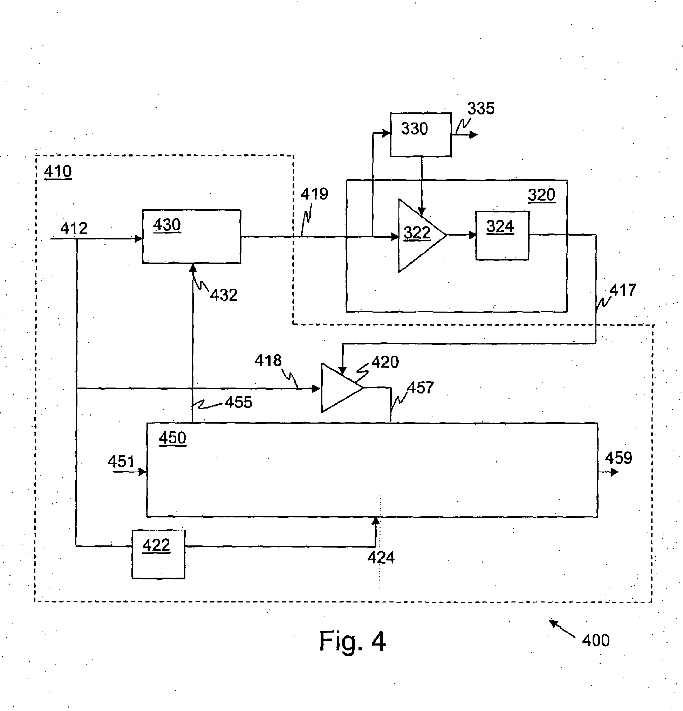

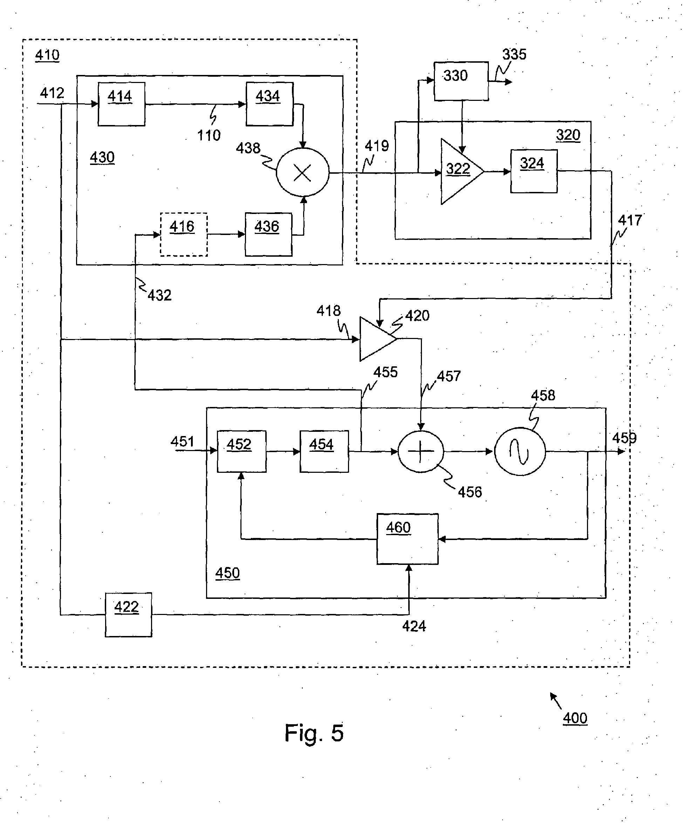

Referring to Figure 4, there is illustrated a feedback system 400 in which the feedback stage 320 and gain controller 330 are as described above, and in which a control system 410 (demarked by a dashed line) comprises a phase locked loop 450 and elements for controlling the phase locked loop 450, including a sign detector 430 for generating the error signal at the ouitput 419, a scaling stage 420 and a filter 422. Figure 5 illustrates the feedback system of Figure 4 with more detail of the phase locked loop 450 and the sign detector 430 shown.

Referring to Figure 5, the phase locked loop 450, which is known in the art, comprises a variable frequency oscillator 458 such as a voltage controlled oscillator or a digitally controlled oscillator. The variable frequency oscillator 458 provides an oscillator signal at an output 459. The output 459 is coupled to an input of a frequency divider 460 for dividing the oscillator signal. An output of the frequency divider 460 provides the divided oscillator signal and is coupled to a first input of a phase comparator 452. A second input 451 of the phase comparator 452 receives a phase reference signal generated by a reference oscillator (not illustrated), such as a crystal oscillator. The phase comparator 452 provides a phase error signal at an output which is coupled to an input of a loop filter 454. The phase error signal is indicative of the phase difference between the phase reference signal and the divided oscillator signal. An output of the loop filter 454 is coupled to an input of the variable frequency oscillator 458 for controlling its frequency in response to the filtered phase error signal.

The performance of the phase locked loop 450 depends, among other things, on the gain of the variable frequency oscillator 458, the gain being a measure of the change of frequency of the variable frequency oscillator 458 in response to a change in the signal applied at its input. As the variable frequency oscillator 458 is typically an analogue circuit, the loop performance is susceptible to variations in analogue circuit characteristics, due to, for example, temperature or voltage changes or manufacturing process spread, which lead to variations in oscillator gain.

When such a phase locked loop is incorporated into a wireless transmitter, in which a carrier signal is modulated by a modulation signal, it can be advantageous to apply the modulation to the phase locked loop, rather than to a mixer which would entail an additional RF circuit. In the control system 410 of Figure 5, two-point modulation is employed in which a modulation signal provided at a moduation input 412 is applied to the input of the variable frequency oscillator 458 via an input 457 of the phase locked loop 450, and is also applied to control the division ratio of the frequency divider 460 via an input 424 of the phase locked loop 450. To effect this, the input 457 is coupled to a first input of a summing stage 456, a second input of the summing stage 456 is coupled to the output of the loop filter 454, and an output of the summing stage 456 is coupled to the input of the variable frequency oscillator 458. The modulation input 412 may be coupled to the frequency divider 460 via an optional third filter 422, which may be a low pass filter, in order to reduce noise.

Variations in the gain of the variable frequency oscillator 458 will lead to variations in the modulated carrier signal at the output 459 of the phase locked loop 450. In particular, if the gain of the variable frequency oscillator 458 is ideal, the transfer function for the modulation from the input of the variable frequency oscillator 458 to the output 459 of the phase locked loop 450, that is the output of the variable frequency oscillator 458, has an all-pass frequency transfer function. However, if the gain of the variable frequency oscillator 458 is too high, high frequencies of the modulation signal are amplified too much, and if the gain of the variable frequency oscillator 458 is too low, high frequencies of the modulation signal are amplified too little.

Therefore, the control system 410 includes additional elements for compensating for variations in gain of the variable frequency oscillator 458 by scaling the modulation signal by means of a scaling stage 420 coupled between the modulation input 412 and the input 457 of the phase locked loop 450. The scaling stage 420 may alternatively be coupled between the output of the summing stage 456 and the input of the variable frequency oscillator 458. In this letter position, both the modulation signal and the filtered error signal are scaled by the scaling stage 420.

The extent of the scaling is controlled by a scaling control signal applied at the input 417 of the control system 410, the input 417 being coupled to a control input of the scaling stage 420. The derivation of the scaling control signal involves the sign detector 430, the feedback stage 320, and the gain controller 330. The feedback stage 330, and the gain controller 330 are as described above, and so they will not be described again.

Before describing embodiments of the sign detector 430, some principles underlying the scaling control will be described. The phase error signal u(s) of a phase locked loop may be expressed as

$$u(s) = \frac{1}{2\pi K_0} \cdot \frac{1-k}{1+\dfrac{1}{L(s)}} \cdot w_m(s) \qquad\qquad (1)$$

where s is the Laplace operator, k is the oscillator gain, $K_0$ is a constant, L(s) is the open loop transfer function, and $w_m$(s) is the modulation signal. Ideally, k=1, so 1-k represents the gain error. As an initial approximation, assume that L(s) is large, so that $1 + 1/L(s) \approx 1$. Therefore,

$$u(s) = \frac{1-k}{2\pi K_0} \cdot w_m(s)$$

If the phase error signal u(s) has the same sign as the modulation signal $w_m$(s), then the gain error *1*-k is positive, which indicates that the oscillator gain is less than one, so is too small. If the phase error signal u(s) has the opposite sign to the modulation signal w(s), then the gain error 1-k is negative, which indicates that the oscillator gain is greater than one, so is too large. It is apparent from equation (1) that

$$\text{sign}(u) = \text{sign}(1-k) \cdot \text{sign}(w_m)$$

where the Laplace operator has been omitted because this is applicable in either the time domain or frequency domain. Thus it can be determined, from the sign of the error signal and of the modulation signal, whether the gain is too small or too large by evaluating:

$$\text{sign}(u).\text{sign}(w_m) = \text{sign}(1-k).\text{sign}^2(w_m)$$

$$\text{i.e. sign}(u).\text{sign}(w_m) = \text{sign}(1-k) \qquad\qquad (2)$$

because $\text{sign}^2(w_m)=1$.

The approximation that L(s) is large is valid at low frequencies where the loop gain is high. However, at high frequencies where the loop gain is lower it is possible that the phase error signal is delayed by 90 degrees with respect to the modulation signal. In this case, multiplying signals that are 90 degrees apart results in a zero average, and not in a valid indication of gain error.

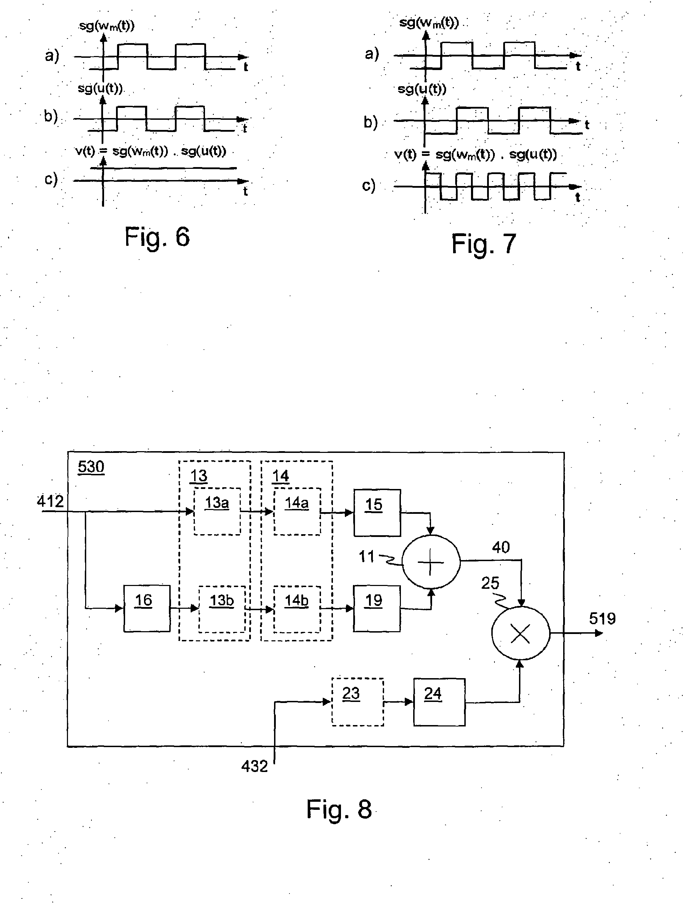

This problem is readily illustrated by means of waveform diagrams. In Figures 6 and 7, "sg" is an abbreviation for the sign function, $w_m(t)$ represents the modulation signal as a function of time t, and u(t) represents the phase error signal as a function of time. Figure 6 illustrates a situation in which the modulation signal and the phase error signal are in-phase, resulting in the product v(t) of their signs being positive. Therefore, according to equation (2), the oscillator gain k is too small. Figure 7 illustrates a situation in which the modulation signal and the phase error signal are 90 degrees out of phase, resulting in the product v(t) of their signs alternating between positive and negative values, and which if averaged would have a mean value of zero.

Therefore, in this case a valid indication of whether k is too large or too small is not generated. As the phase difference between the modulation signal and the phase error signal approaches 90 degrees, the indication decreases to zero and so becomes progressively unreliable. If the phase difference approaches 180 degrees, the phase error signal changes sign and an erroneous indication of whether k is too large or too small is generated.

The analysis above demonstrates that the relative phase, or delay, of the modulation signal and the phase error signal affects the reliability of calibration. Therefore, the filter 414 which coupled to the modulation input 412 is arranged to have a transfer function which provides a delay equal to the delay between the modulation signal applied at the modulation input 412 and a consequent response in the phase error signal at the point in the sign detector 430 where the sign of the phase error signal is determined. In this way, the relative delay between the modulation signal and the phase error signal, at the point in the sign detector 430 where the sign of the modulation signal is determined and the sign of the phase error signal is determined, is removed. The transfer function of the first filter 414 is selected to remove this relative delay as a function of frequency across the bandwidth of the phase locked loop 450. This provides a gain compensation scheme which is independent of the spectral content of the modulation signal. In the simplest form, the phase error signal output 455 of the phase locked loop 450 is coupled directly to an input of a comparator 436, in which case the transfer function of the filter 414 mimicks the transfer function of the phase locked loop 450, that is the delay, as a function of frequency, between providing a modulation signal at the modulation input 412 and the resulting change in the phase error signal at the output 455 of the phase locked loop 450.

In a variation, it may be advantageous to provide further filtering of the phase error signal by means of an optional filter 416, as illustrated in Figure 5, in order to reduce noise. In this case, any delay introduced by the filter 416 should also be applied to the modulation signal as well. In this case, the transfer function of the filter 414 corresponds to the combination of the transfer function of the phase locked loop 450 plus the transfer function of the filter 416. Such a combination may be implemented as a single filter or a combination of more than one filter.

By filtering the modulation signal as described above, an indication can be generated of whether the gain k of the oscillator is too small or too large, independent of the spectral content the modulation signal.

In a further variation, the phase error signal may be extracted from the phase locked loop 450 at the output of the phase comparator 452, instead of at the output of the loop filter 454.

The sign detector 430 further comprises a first comparator 434 and a second comparator 434. The first comparator 434 is coupled to an output of the first filter 414 for comparing the modulation signal, after filtering by the first filter 414, with a first threshold value, and for providing at an output of the first comparator 434 a first sign signal indicative of whether the modulation signal is greater than or less than the first threshold. Preferably any DC component of the modulation signal is removed, in which case the first threshold value can be zero. The first sign signal provided at the output of the first comparator 434 is a bipolar signal, and preferably has a value +1 or -1 according to whether the modulation signal is greater than or less than the first threshold.

The second comparator 436 is coupled to the second input 432 of the sign detector 430, in particular to the output of the filter 416 if present, for comparing the phase error signal with a second threshold value, and for providing at an output of the second comparator 436 a second sign signal indicative of whether the phase error signal is greater than or less than the second threshold. Preferably any DC component of the phase error signal is removed, in which case the second threshold value can be zero. The second sign signal provided at the output of the second comparator 436 is a bipolar signal, and preferably has a value +1 or -1 according to whether the phase error signal is greater than or less than the second threshold.

The output of the first comparator 434 and the output of the second comparator 436 are coupled to respective inputs of a multiplier 430 which multiplies the first and second sign signals and provides at an output an indication of whether the first and second sign signals have the same sign, thereby providing an indication of whether the modulation signal and the phase error signal have the same sign relative to their respective first and second threshold values. The output of the multiplier 430 is coupled to the output 419 of the control system 410, which is coupled to the input of the feedback stage 320. If the first and second sign signals can both have values +1 and -1, the indication at the output of the multiplier 438 will have a value +1 if both sign signals have the same value, in which case the scaling control signal delivered by the feedback stage 320 to the input 417 of the control system 410 causes the scaling factor applied to the modulation signal by the scaling stage 420 to increase, and a value -1 if the sign signals have different values, in which case the scaling control signal delivered by the feedback stage 320 to the input 417 of the control system 410 causes the scaling factor applied to the modulation signal by the scaling stage 420 to decrease.

Referring to Figure 8, there is illustrated an alternative sign detector 530 which may be used instead of the sign detector 430, having a different architecture and operating in a different way. Before describing embodiments of the sign detector 530, the principles underlying its operation will be described.

Figure 7 illustrates a situation in traces (a) and (b) in which the sign of the modulation signal $w_m(t)$ and the sign of the phase error signal $u(t)$ are 90 degrees out of phase. The sign detector 530 employs the phase $\Phi_m(t)$ of the modulation signal, the sign of which is shown in trace (c). The waveforms of $sg(\Phi_m(t))$ and $sg(w_m(t))$ may be visualised as cosine and sine waves which have been limited. Trace (d) illustrates the sum of the signs of the modulation signal and the phase of the modulation signal. Where the sign of $w_m(t)$ and $\Phi_m(t)$ is different, the sum is zero, and where these signs are the same, the sum is either positive or negative. Trace (e) illustrates the waveform of trace (d) multiplied by the sign of the error signal $u(t)$. Now, despite the 90 degree phase shift between the modulation signal and the error signal, a positive signal is generated periodically, and this has a positive mean value. Corresponding examples can be generated for other phase shifts, which demonstrate that a non-zero mean value results, which can be used for compensation of the oscillator gain, including a phase shift of around 180 degrees. Thus, by employing the phase of the modulation signal, an indication can be generated of whether the gain k of the oscillator is too small or too large, independent of phase shift between the modulation signal and the phase error signal. In this way, the adjustment the value of k is independent of the frequency content of the modulation signal and independent of the phase response of the phase locked loop.

Referring to Figure 8, the sign detector 530 comprises a first comparator 15 coupled to the modulation input 412 for comparing the modulation signal with the first threshold value, and for providing at an output of the comparator 15 a first sign signal indicative of whether the modulation signal is greater than or less than the first threshold. Preferably any DC component of the modulation signal is removed, in which case the first threshold value can be zero. The first sign signal provided at the output of the comparator 15 is a bipolar signal, and preferably has a value +1 or -1 according to whether the modulation signal is greater than or less than the first threshold.

Also coupled to the modulation input 412 is a phase determination stage 16 for determining a phase signal indicative of the phase of the modulation signal. The phase determination stage 16 may be, for example, an integrator. Alternatively, the phase determination stage 16 may be omitted and the sign detector 530 supplied with the phase signal on a further input (not illustrated). An output of the phase determination stage 16 is coupled to an input of a second comparator 19 for comparing the phase signal with the second threshold value, and for providing at an output of the comparator 19 a second sign signal indicative of whether the phase signal is greater than or less than the second threshold. Preferably any DC component of the phase signal is removed, in which case the second threshold value can be zero. The second sign signal provided at the output of the comparator 19 is a bipolar signal, and preferably has a value +1 or -1 according to whether the phase signal is greater than or less than the second threshold.

The output of the comparator 15 and the output of the comparator 19 are coupled to respective inputs of a summer 11 which sums the first and second sign signals and provides at an output 40 an indication of whether the first and second sign signals have the same sign, thereby providing an indication of whether the modulation signal and the phase of the modulation signal have the same sign relative to their respective first and second threshold values. If the first and second sign signals can both have values +1 and -1, the indication at the output 40 of the summer 11 can have values +2, 0 and -2. The value zero occurs when the modulation signal and the phase of the modulation signal have the different signs, and the values +2 and -2 occur when modulation signal and the phase of the modulation signal have the same sign.

The sign detector 530 further comprises a third comparator 24 for comparing the phase error signal provided at the input 432 with a third threshold value, and for providing at an output of the third comparator 24 a third sign signal indicative of whether the phase error signal is greater than or less than the third threshold. Preferably any DC component of the error signal is removed, in which case the third threshold value can be zero. The third sign signal provided at the output of the comparator 24 is a bipolar signal, and preferably has a value +1 or -1 according to whether the phase error signal is greater than or less than the third threshold.

The output of the comparator 24 is coupled to a first input of a multiplier 25, and the output 40 is coupled to a second input of the multiplier 25. The multiplier 25 multiplies the third sign signal by the indication of whether the modulation signal and the phase of the modulation signal have the same sign, which is provided at the output 40 of the summer 11 of the sign detector 10. When the third sign signal can have values +1 and -1, and the indication provided at the output of the summer 11 can have the values +2, 0 and -2, the values resulting from multiplication by the multiplier 25 can have also the values +2, 0 and -2. The value zero occurs when the modulation signal and the phase of the modulation signal have the different signs, and the values +2 and -2 occur, dependent on the sign of the phase error signal, when modulation signal and the phase of the modulation signal have the same sign. An output of the multiplier 25 is coupled to the output 419 of the control system 410

Optionally, the sign detector 530 may comprise a delay stage 13a and a filter 14b, either or both of which may be coupled between the modulation input 412 and the comparator 15 to delay and/or filter the modulation signal. Likewise, optionally a delay stage 13b and/or a filter 14b may be coupled between the phase determination stage 16 and the comparator 15 to delay and/or filter the phase signal. The delay stages 13a and 13b (together identified by reference numeral 13) and filters 14a and 14b (together identified by reference numeral 14) may be used to fully or partially compensate for unequal delays of signals in the control system 410 and to reduce noise. Alternatively, the delay stages 13a and 13b may be located after, respectively, the first and second comparators 15, 19, to delay the first and second bipolar signals. Also, the delay stages 13a and 13b may be omitted if the filters 14a and 14b provide the required delay.

Optionally, the sign detector 530 may comprise a filter 23 coupled between the input 432 and the comparator 24 for filtering the phase error signal to reduce noise. However, the filter 23 may introduce a delay which may lead to instability unless further precautions are taken. In this case, the filters 14a and 14b and/or the delay stages 13a and 13b may be arranged to provide a compensating delay for the modulation signal and the phase signal.

In the feedback systems described with reference to Figures 4 to 8 in which the control system 410 comprises a phase locked loop 450, the control signal, as referred to in the claims, may be regarded as corresponding to the scaling control signal, so in these embodiments the feedback signal equates to the control signal. However, this is not an essential condition, so in other embodiments the feedback signal may not equate to the control signal. In general, the control signal may be any signal in the control system that varies in response to the feedback signal. Furthermore, the convergence value of the scaling signal is the value that exactly compensates for the gain error 1-k, which is the value of the scaling signal when the feedback system converges to a stable condition. This, in general, the convergence value need not be a predetermined value, but may be determined by a predetermined condition to which the control system converges.

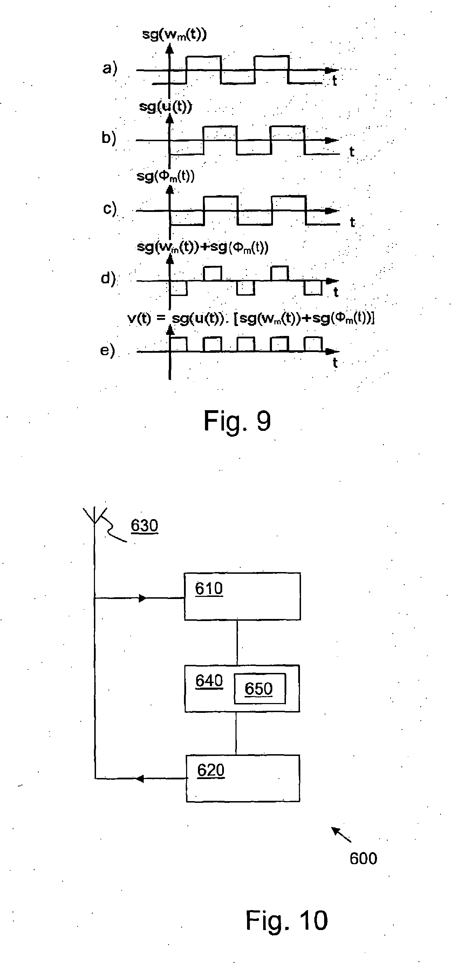

The feedback system 400 comprising a phase locked loop may be part of a communication apparatus. Referring to Figure 10, there is illustrated a communication apparatus 600 comprising a transmitter 610 and a receiver 620. The transmitter 610 has an output coupled to an antenna 630, and the receiver has an input coupled to the antenna 630. Coupled to the transmitter 610 and the receiver 620 there is a feedback system 640 comprising a phase locked loop 650 for generating a local oscillator signal for use in frequency upconversion in the transmitter 610 and frequency downconversion in the receiver 620.

Any or all elements of the feedback system may be implemented in analogue or digital hardware or in software executed by a processor such as a digital signal processor (DSP) or central processing unit (CPU). Indeed, it can also be appreciated that the invention can be implemented using computer program code or computer software. The computer software or computer program code can be carried by a computer readable medium. The medium may be a physical storage medium such as a Read Only Memory (ROM) chip. Alternatively, it may be a disk such as a Digital Versatile Disk (DVD-ROM) or Compact Disk (CD-ROM). It could also be a signal such as an electronic signal over wires, an optical signal or a radio signal such as to a satellite or the like.

From reading the present disclosure, other variations and modifications will be apparent to the skilled person. Such variations and modifications may involve equivalent and other features which are already known in the art of feedback systems, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable subcombination.

The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

**Claims**

1.  A feedback system (300) comprising:

    - a control system (310) having an input (312) for a feedback signal and an output (314), the control system (310) being responsive to the feedback signal and adapted to provide at the output (314) an error signal indicative of whether a control signal in the control system (310) is above or below a convergence value;
    - a feedback stage (320) coupled between the output (314) and the input (312) for generating the feedback signal from the error signal, the feedback stage (320) having a variable gain stage (322); and
    - a gain controller (330) coupled to the output (314) of the control system (310) and to an input of the variable gain stage (322) and adapted to, in response to the error signal indicating that the control signal has crossed the convergence value, reduce the gain of the variable gain stage (322).

2.  A feedback system (300) as claimed in claim 1, wherein the error signal is a digital signal.

3.  A feedback system (300) as claimed in claim 2, wherein the digital signal is a binary signal.

4.  A feedback system (300) as claimed in any preceding claim, the feedback stage (320) further having an integration stage (324).

5.  A feedback system (300) as claimed in any preceding claim, wherein the control signal is the feedback signal.

6.  A feedback system (300) as claimed in any preceding claim, wherein the control system (310) comprises a phase locked loop (400).

7.  A communication apparatus (500) comprising the feedback system (300) as claimed in any preceding claim.

8.  A method of operating a feedback system (300) comprising a control system (310) responsive to a feedback signal, the method comprising:

    - generating an error signal indicative of whether a control signal in the control system (310) is above or below a convergence value;
    - generating the feedback signal from the error signal; and
    - in response to the error signal indicating that the control signal has crossed the convergence value, reducing the gain of the feedback signal.

9.  A method as claimed in claim 8, wherein the error signal is a digital signal.

10. A method as claimed in claim 9, wherein the digital signal is a binary signal.

11. A method as claimed in any one of claims 8 to 10, said generating further including integration.

12. A method as claimed in any one of claims 8 to 11, wherein the control signal is the feedback signal.

13. A method as claimed in any one of claims 8 to 12, wherein the control system comprises a phase locked loop.

14. Computer program code for performing the method of any one of claims 8 to 13.

Fig. 1   PRIOR ART

Fig. 2   PRIOR ART

Fig. 3

Fig. 4

Fig. 5

Fig. 6

Fig. 7

Fig. 8

a) $sg(w_m(t))$

b) $sg(u(t))$

c) $sg(\Phi_m(t))$

d) $sg(w_m(t))+sg(\Phi_m(t))$

e) $v(t) = sg(u(t)) \cdot [sg(w_m(t))+sg(\Phi_m(t))]$

Fig. 9

630

610

640    650

620

600

Fig. 10

Europäisches
Patentamt

European
Patent Office

Office européen
des brevets

# EUROPEAN SEARCH REPORT

**Application Number**

EP 08 29 0464

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 027 087 A (ROTTINGHAUS) 25 June 1991 (1991-06-25) * column 2, line 9 - column 4, line 62; figures 1,2 * ----- | 1,8 | INV. H03C3/09 |
| A | US 2004/036539 A1 (HAMMES M.) 26 February 2004 (2004-02-26) * paragraph [0030] - paragraph [0042]; figure 1 * ----- | 1-14 | |

**TECHNICAL FIELDS SEARCHED (IPC)**

H03C

The present search report has been drawn up for all claims

| Place of search | Date of completion of the search | Examiner |
|---|---|---|
| The Hague | 4 December 2009 | Butler, Nigel |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

....................................................................

& : member of the same patent family, corresponding
   document

EPO FORM 1503 03.82 (P04C01)

**ANNEX TO THE EUROPEAN SEARCH REPORT**
**ON EUROPEAN PATENT APPLICATION NO.**

EP 08 29 0464

This annex lists the patent family members relating to the patent documents cited in the above-mentioned European search report.
The members are as contained in the European Patent Office EDP file on
The European Patent Office is in no way liable for these particulars which are merely given for the purpose of information.

04-12-2009

| Patent document cited in search report | | | Publication date | Patent family member(s) | | | Publication date |
|---|---|---|---|---|---|---|---|
| US 5027087 | A | | 25-06-1991 | AU | 633228 | B2 | 21-01-1993 |
| | | | | AU | 8851891 | A | 21-08-1991 |
| | | | | CA | 2049346 | A1 | 03-08-1991 |
| | | | | EP | 0440449 | A2 | 07-08-1991 |
| | | | | JP | 4506737 | T | 19-11-1992 |
| | | | | WO | 9111852 | A1 | 08-08-1991 |
| US 2004036539 | A1 | | 26-02-2004 | CN | 1524336 | A | 25-08-2004 |
| | | | | WO | 02067428 | A2 | 29-08-2002 |
| | | | | DE | 10108636 | A1 | 19-09-2002 |
| | | | | EP | 1362413 | A2 | 19-11-2003 |

EPO FORM P0459

For more details about this annex : see Official Journal of the European Patent Office, No. 12/82